# EUROPEAN PATENT SPECIFICATION

(11) **EP 2 784 020 B1**
(45) Date of publication and mention of the grant of the patent: **27.04.2016**
(21) Application number: 13161375.4
(22) Date of filing: 27.03.2013
(51) Int. Cl.: G01R 33/09, G11C 11/16, H01L 43/08, H01L 43/10

(54) **Spin torque magnetic integrated circuit**
Spindrehmoment-Magnetschaltung
Circuit intégré magnétique à couple de spin

(43) Date of publication of application: 01.10.2014
(73) Proprietor: Technische Universität Wien, 1040 Wien (AT)
(72) Inventor: Windbacher, Thomas, 2722 Winzendorf (AT); Sverdlov, Viktor, 2275 Bernhardsthal (AT); Selberherr, Siegfried, 3430 Tulln (AT); Mahmoudi, Hiwa, 1140 Vienna (AT)
(74) Representative: Patentanwälte Puchberger, Berger und Partner

(56) References cited:
- US-A1- 2011 147 816
- WINDBACHER THOMAS ET AL: "Rigorous simulation study of a novel non-volatile magnetic flip-flop", 2013 INTERNATIONAL CONFERENCE ON SIMULATION OF SEMICONDUCTOR PROCESSES AND DEVICES (SISPAD), IEEE, 3 September 2013 (2013-09-03), pages 368-371, XP032518459, ISSN: 1946-1569, DOI: 10.1109/SISPAD.2013.6650651 ISBN: 978-1-4673-5733-3 [retrieved on 2013-10-30]
- WINDBACHER THOMAS ET AL: "Novel MTJ-based shift register for non-volatile logic applications", 2013 IEEE/ACM INTERNATIONAL SYMPOSIUM ON NANOSCALE ARCHITECTURES (NANOARCH), IEEE, 15 July 2013 (2013-07-15), pages 36-37, XP032498566, DOI: 10.1109/NANOARCH.2013.6623038 [retrieved on 2013-10-06]

## Description

The invention relates to a spin torque integrated circuit according to the preamble of claim 1, a flip flop circuit comprising such a circuit, a shift register comprising such a flip flop, and methods to operate these circuits.

Scaling CMOS technology has provided high density, high speed, and low power consumption electronic circuits. However, due to the constant shrinking of device dimensions the leakage currents - especially at standby - have become a serious issue. A possible solution to circumvent the standby power problem is to introduce non-volatile information storage in logic circuits. These circuits can be shut down completely without loss of information and energy is only consumed when logic states are changed.

Ideally, a complete circuit could be powered off, while all data are protected, and instantly available when the power is up again. For achieving this goal one needs to introduce non-volatility in basic building blocks like Flip Flops (FF). Non-Volatile FFs (NVFF) store intermediate computing data in non-volatile mode and offer these immediately when the circuit is re-powered.

Due to its high endurance, fast speed, low power consumption, and small area Spin-Transfer Torque Memory (STTM) devices are attractive candidates for realizing such NVFF.

The document WO 2011/075257 A2 discloses a spin torque magnetic integrated circuit, comprising a ferromagnetic free layer with a magnetic anisotropy with at least two stable magnetic states disposed on a substrate, a first non-magnetic layer disposed on a first side of the free layer, several input regions disposed on the non-magnetic layer, each comprising a ferromagnetic fixed input reference layer, several output regions disposed on the non-magnetic layer, comprising at least one ferromagnetic fixed output reference layer, and capping layers to electrically contact the input regions and output region.

However, the disclosed circuit is not suited for sequential logic needed for flip flop operations because it is an essential requirement of the described circuit that a multitude of input regions - that is, more than two - is provided, and the output signal exclusively depends on the majority of the input signals.

Therefore, the objective of the invention is to provide a non-volatile magnetic integrated circuit that enables sequential operations such as flip flop or shift register operation, while saving die space as compared to conventional circuits. A further objective is to provide methods to operate such circuits to enable sequential operations.

To overcome the above described problem, a spin torque magnetic integrated circuit is presented in which only two input regions are disposed on the non-magnetic layer, at least one of the input regions comprises at least one magnetic input reference layer, and the orientation of the magnetization vectors of the input reference layers, the output reference layer, and the orientation of the magnetic anisotropy of the free layer are chosen in such a way that they are collinear. This allows to use two and only two input regions for operation, and makes flip flop operation possible. Flip flop logic is realized in the magnetic domain by creating constructive or destructive superposition of two spin disturbances which are synchronously generated at the input regions. The operation result is saved via the magnetization orientation in the shared free layer, and can be read out by suitable sensing circuits.

The disclosed magnetic flip flop circuit is superior to conventional flip flop circuits, because instead of eight CMOS transistors (non clocked) or twelve CMOS transistors (clocked) for a classic RS flip flop or seven transistors and two magnetic tunnel junction memory elements for a non-volatile flip flop, only one non-volatile magnetic flip flop is needed. Thus the invented non-volatile magnetic flip flop saves die space and eases large scale integration. In contrast to CMOS RS flip flops there are no forbidden input combinations and thus circuit design is eased further.

Stacking and arrangement of several of these devices and their intrinsic logic allow the creation of an extremely dense shift register. By arranging the flip flops in two or more levels and applying two phase shifted clocking signals, the flip flops couple in a way that the information held by one shared free layer is successively passed via spin-transfer torque effect to the corresponding next shared free layer. By this means, shift register operation can be achieved.

Both input regions may comprise at least one magnetic input reference layer. The magnetization vectors of the input reference layers may have the same direction or the opposite direction as the magnetization vector of the output reference layer, depending on the polarity of the input signals. The input reference layers and the output reference layers might comprise ferromagnetic, anti-ferromagnetic, or synthetic anti-ferromagnetic layers. According to an embodiment of the invention, only a single input reference layer comprises a ferromagnetic, anti-ferromagnetic, or synthetic anti-ferromagnetic fixed layer.

According to an embodiment of the invention, the easy axis of the magnetic anisotropy of the free layer, the input reference layer, and the output reference layer may be oriented substantially in-plane with the substrate. This might be necessary if the respective layers have a magnetic shape anisotropy, such as for a bar shape or an elliptic shape.

According to a further embodiment of the invention the easy axis of the magnetic anisotropy of the free layer, the input reference layer, and the output reference layer may be oriented substantially out-of-plane in relation to the substrate. This might be possible if the respective layers have a magnetic crystal anisotropy.

Accordingly, the shape of the shared free layer may be bar like or elliptical in order to create an in-plane shape anisotropy needed for operation, but could be in principal of an arbitrary geometry if the anisotropy is material-induced such as for an out-of-plane anisotropy.

It is further provided that a second non-magnetic layer might be disposed on a second side of the free layer, and at least one electrically contactable input and/or output region comprising at least one magnetic fixed reference layer is disposed on the second non-magnetic layer. This enables to double the STT at operation in case of a geometrically symmetric stack and opposing reference layer magnetization, and therefore to reduce the switching current.

It is further provided that the layout of the free layer might have a y-shape where the two input regions and the output region are located on separate legs, and the angle between the input regions is between 0° and 180°, preferably between 30° and 120°.

The width of the shared free layer may be between 10 nm to 100 nm, its length between 2 to 10 times the width, preferably between 3 to 5 times the width, and its thickness may be in the range from 0.5 nm to 50 nm. Particularly, the width of the free layer can be between 10nm and 100nm, its length between 20nm and 1000nm, preferably between 30nm and 500nm, and its thickness between 0.5nm and 50nm.

The shared free layer may be composed of a ferromagnetic, an anti-ferromagnetic or a synthetic anti-ferromagnetic material. An out-of-plane crystal anisotropy may be realized if the shared free layer comprises terbium cobalt iron (TbCoFe) or cobalt platinum (CoPt) layers. Furthermore, a synthetic anti-ferromagnetic stack with crossing layers can form or be part of the shared free layer.

The non-magnetic layer may comprise an insulator such as an oxide like aluminum dioxide (Al₂O₃) or magnesium oxide (MgO). The non-magnetic layer may also comprise a metal such as copper or aluminum. Its thickness may range from 0.5 nm to 10 nm. The non-magnetic layer may be deposited above and/or below the shared free layer. It may comprise a single layer or a layer stack. It fulfils several purposes. On one hand, it works as a spin tunnel barrier and on the other hand it may be utilized to either electrically insulate or electrically contact a certain region.

It is further provided that the non-magnetic layer may cover the shared free layer completely or partially. Particularly, it might be advantegeous for certain embodiments if the non-magnetic layer covers the shared free layer only in the signal input regions and the signal output region.

The signal input region and the signal output region comprise a reference layer which may comprise a layer stack fixing its magnetization. For instance a pinning layer, a coupling layer, and a pinned layer or an (synthetic) anti-ferromagnetic layer, a coupling layer, and a ferromagnetic layer might be used. It may comprise partly another shared free layer in order to couple to another non-volatile magnetic integrated circuit.

The output region may be placed in the middle between two input regions, or on either side of the signal input region. Additionally one may supply the non-volatile magnetic integrated circuit and the non-volatile shift register with a small power source which will ensure safely defined states when the main power fails or the whole device is turned off.

There may also be a corresponding contact layer structure on the opposite side of the shared free layer to guarantee a perpendicular current flow to maximize the STT effect. This layer structure may be similar to the upper layer stack in order to reduce the switching current by a second STT contribution. Preferably, the spin torque from the second interface may be parallel to the spin torque from the first interface, otherwise the STT contributions would at least partially cancel each other out.

The stable magnetization states of the signal input regions and the signal output regions is preferably collinear to the magnetization in the shared free layer and either parallel or anti-parallel oriented.

The invention further relates to a method to operate a spin torque magnetic integrated circuit according to the invention, wherein the method comprises the following steps: First, electrical current or voltage signals representing logic states are applied simultaneously at the two signal input regions. Then, the electrical current or voltage signals and any sensing currents or voltages are removed for a certain time period to relax the magnetic state of the integrated circuit. Within a time period, the logic state of the shared free layer is read out by a sense amplifier utilizing a sensing current or sensing voltage. Preferably, the time period is long enough to let the free layer relax to about 80% of its final state.

According to the invention, the logic state of the shared free layer might be read out by sensing the difference in electrical resistance for parallel and anti-parallel orientation of the input or output regions to the reference layer magnetization. Particularly, the logic state of the shared free layer might be read out by passing the magnetization via STT operation to an adjacent shared free layer of a second non-volatile magnetic integrated circuit.

The invention relates further to an integrated circuit comprising a first integrated circuit as described above, and a second circuit as described above, wherein at least one reference layer of the second circuit comprises a part of the free layer of the first circuit. The first circuit and the second circuit might be arranged in different levels, and they are preferably stacked to save die space. Particularly, the reference layer of a signal input region of the second circuit might comprise the shared free layer of the first circuit. In such an arrangement, it is possible to stack several integrated circuits operated as flip flops together, so that a shift register operation is achieved.

It is further provided that at least a third integrated circuit is provided, where at least one of the reference layers of the third circuit comprise the shared layer of any of the first or second circuit. This can be repeated as often as necessary, to realize a shift register with the desired number of stages.

The invention is further related to a method to operate such an arrangement comprising two integrated circuits connected together and operating as flip flops, wherein a first clock signal is applied to the input region of the first circuit and a second clock signal is applied to the input region of the second circuit and the first clock signal and the second clock signal are phase-shifted, wherein the first clock signal and the second clock signal are preferably provided in such a way that there is a relaxation time window between the pulses of the clock signals in which the first circuit and the second circuit are unpowered.

Further features of the invention become evident from the description of the embodiments, the figures, and the claims.

A detailed description of several embodiments of the invention is given below.
- Fig. 1a-1c:: Schematic cross-section of a spin torque integrated circuit according to the invention;
- Fig. 2a-2c:: Schematic cross-section of a spin torque integrated circuit according to the invention;
- Fig. 3a-3c:: Schematic cross-section of a spin torque integrated circuit according to the invention;
- Fig. 4:: Truth table of a non-volatile magnetic flip flop according to the invention;
- Fig. 5:: Truth table of a non-volatile magnetic flip flop according to the invention;
- Fig. 6:: Top view of an alternative non-volatile magnetic flip flop layout according to the invention;
- Fig. 7a:: Circuit diagram of a proposed non-volatile shift register operating with AB flip flop logic;
- Fig. 7b:: Top view of a first non-volatile shift register layout according to the invention;
- Fig. 7c:: Schematic cross-section of a first non-volatile shift register according to the invention;
- Fig. 7d:: Timing diagram of a non-volatile shift register according to the invention;
- Fig. 8a:: Schematic top view of a second non-volatile shift register according to the invention,
- Fig. 8b:: Schematic cross-section of the second non-volatile shift register layout.

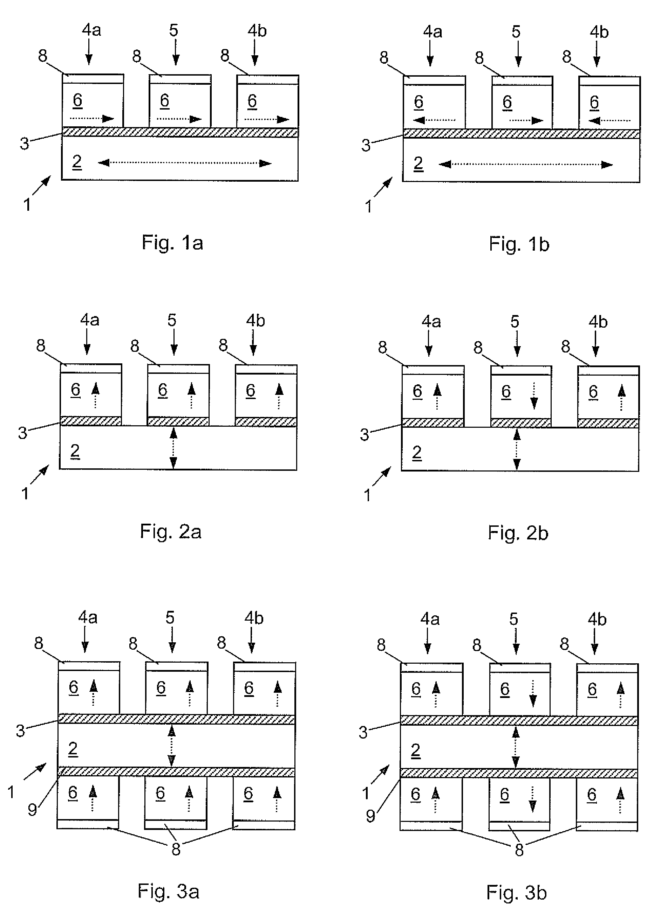

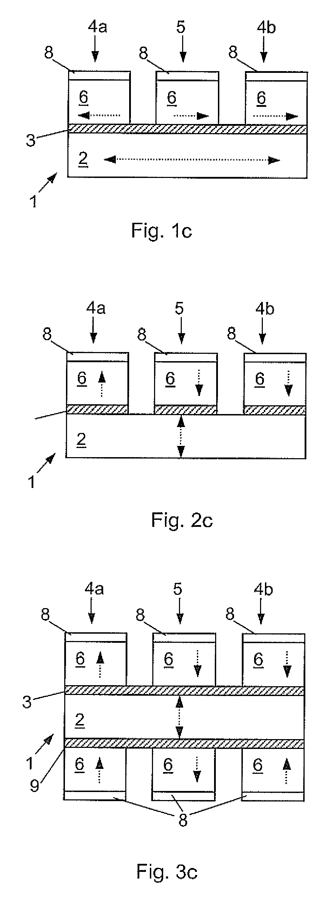

Figs. 1 to 3 show several embodiments of non-volatile magnetic integrated circuits 1 comprising a shared free layer 2, a first non-magnetic layer 3, two signal input regions 4a, 4b, and at least one signal output region 5. The shared free layer 2 may be deposited as whole or partially above a substrate. It exhibits a magnetic anisotropy which may be a shape anisotropy and/or a crystal anisotropy, which defines two stable magnetic states. In the embodiments of Figs. 2a, 2b, 3a, and 3b, the magnetic anisotropy of the shared free layer 2 is a crystal anisotropy. The easy axis of the anisotropy is either oriented in-plane, as in Fig. 1 a and 1 b, or out-of-plane, as in Fig. 2a and 2b.

The non-magnetic layer 3 works as a spin tunnel barrier and it may also be utilized to either electrically insulate or electrically contact a certain region. Therefore, it may consist of an oxide e.g. aluminum dioxide (Al₂O₃), magnesium oxide (MgO), etc. or of a metal e.g. copper, aluminum, etc. In Figs. 1 a to 1 b it is deposited above the shared free layer 2 and covers the shared free layer 2 completely. Its thickness ranges from 0.5 nm to 10 nm. In Figs. 2a and 2b, it is deposited only partially on the shared free layer 2 in the region where the reference layers 6 are deposited. In Figs. 3a and 3b, a second non-magnetic layer 9 is deposited on the back side of the shared free layer 2.

The signal input regions 4a, 4b and the signal output region 5 are disposed on the non-magnetic layer 3. Each of these layers contains a reference layer 6 which may comprise a layer stack fixing its magnetization. The reference layer may comprise the shared free layer of a different magnetic circuit in order to couple to another non-volatile magnetic integrated circuit 1. Additionally, the signal input regions 4a, 4b and the signal output region 5 comprise a capping layer 8 to electrically contact the structure.

Figs. 3a and 3b show that there may also be corresponding contact layer structures 8 on the back side of the shared free layer 2 to guarantee a perpendicular current flow to maximize the STT effect. This layer structure is similar to the upper layer stack in order to reduce the switching current by a second STT contribution.

If the layer structure is identical its magnetization should point in the opposite direction of the first layer. In a further embodiment not shown, the layer structure on the back side of the shared free layer 2 is different from the upper layer structure.

Figs. 1c, 2c, and 3c show further embodiments of the integrated circuits according to the invention, in which the direction of the magnetization vectors in the input regions 4a, 4b are anti-parallalel.

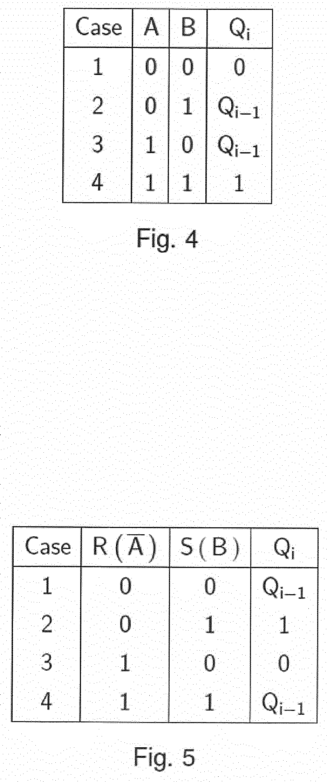

The stable magnetization states of the signal input regions 4a, 4b and the signal output region 5 are shown by the dotted arrows and are collinear to the magnetization in the shared free layer 2 and either parallel or anti-parallel oriented.
To operate the described circuit 1, the method according to the invention is described below, making use of the truth tables in Fig. 4 and Fig. 5. The method comprises the following steps: First, electrical current or voltage signals A and B representing logic states are applied simultaneously at the two signal input regions. For instance, a positive current or voltage pulse denotes logic 1 and a negative current or voltage pulse represents logic 0.

Applying a current or voltage pulse to a signal input region 4a causes a STT operation in the shared free layer 2 at the region where the shared free layer 2 overlaps with the signal input region 4a. The onset of the input pulse generates a spin disturbance which travels through the shared free layer 2 heading to the opposite boundary of the shared free layer 2 where it is reflected and additionally pushed by STT exerted in the second signal input region 4b.

Due to this kind of oscillating motion, the spin disturbance gains power over time and the localized precessing motions successively increase up to the point where they overcome the energy threshold separating the two stable states. Once the magnetization is flipped the STT changes from enhancing the precessional motion to damping the precessional motion so it will relax to its new stable state fast.

In Fig. 4 and Fig. 5, the signals in the two signal input regions 4a, 4b are denoted A and B. The symbol Qᵢ denotes the output of time step i. There are two types of flip flop logic available. AB flip flop logic is shown in Fig. 4, and RS flip flop is shown in Fig. 5.

The AB flip flop sets its state Qᵢ to 1 if both inputs (A and B) are set to 1, sets its state to 0 if both inputs are set to 0, and holds its state Qᵢ = Qᵢ₋₁ if they are unequal. For this flip flop the magnetization vectors of the input reference layers must both have the same direction.

Two spin disturbances are synchronously generated. They can exhibit the same phase angle, corresponding to Case 1 and 4 in Fig. 4 or Case 2 and 3 in Fig. 5. If they are generated by oppositely oriented spin transfer torques, the disturbances have a 180° phase shift, corresponding to Case 2 and 3 in Fig. 4 or Case 1 and 4 in Fig. 5.

In the cases where the two spin disturbances posses no phase shift, the disturbances superimpose constructively which leads to an enhanced switching speed, while when the two disturbances are inverse to each other they superimpose destructively which represses the precession built up and prevents switching.
Thus, by applying simultaneous positive or negative voltage/current pulses the magnetization state of the shared free layer 2 can be set, reset, or held unchanged as needed for flip flop operation.

The RS flip flop is realized by inverting one of the signal inputs, e.g. A in Fig. 5. It sets its state Qᵢ to 1 if R = A̅ = 0 (R denotes reset) and S = B = 1 (S denotes set), sets its state Qᵢ to 0 if R = 1 and S = B = 0, and holds its state Qᵢ = Qᵢ₋₁ if they are equal as shown in Fig. 5. The inversion can be realized in several ways. One may invert the input current or voltage pulse polarity or may make the STTs act in opposite directions. In one embodiment, the magnetic vectors of the input reference layers 6 have opposite directions. In a further embodiment, one may utilize a synthetic anti-ferromagnetic stack with crossing layers (upper (lower) layer goes down (up) joining layer from an adjacent synthetic anti-ferromagnetic stack) for the shared free layer 2.

Within a time period, the logic state of the shared free layer is read out by a sense amplifier utilizing a sensing current or sensing voltage. If the reading currents or voltages are small enough to prevent undesired switching events, the signal input regions 4a, 4b can be used for sensing the logic state Qᵢ represented by the magnetization of the shared free layer 2. It may be read out by sensing the difference in electrical resistance for parallel and anti-parallel orientation to the reference layer magnetization and a sense amplifier.

Alternatively, the logic state Qᵢ may be passed on via STT to an adjacent shared free layer 2 of a neighboring non-volatile magnetic integrated circuit 1. After reading, the electrical current or voltage signals and any sensing currents or voltages are removed for a certain time period to relax the magnetic state of the spin torque magnetic integrated circuit.

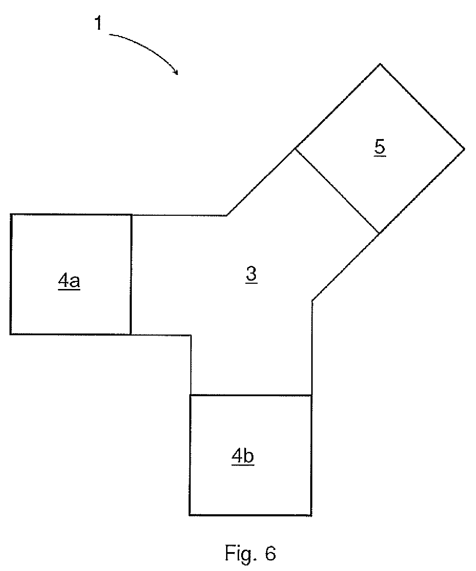

Fig. 6 shows an alternative embodiment of a non-volatile magnetic integrated circuit 1 featuring a y-shaped layout. The angle between the signal input regions 4a and 4b is approximately 90°. If the circuit is used for flip flop operation, the two simultaneously generated spin disturbances are scattered at the leg intersection and only a part of the incoming spin disturbances contributes to switch the leg containing the signal output region 5, which is electrically inactive during write operation, and the before described resonance effect is strongly reduced causing higher switching currents. However, it may be useful when due to space constraints it is necessary to place the signal output region 5 separate from the signal input regions 4a, 4b.

For demonstration purposes simulations a set of simulations of non exclusive embodiments of non-volatile magnetic integrated circuits 1 have been carried out. Metal non-magnetic layers 3 causing a current spin polarization of P = 0.3, a magnetization saturation Mₛ = 4 x 10⁵ A/m, an outof-plane uni axial crystal anisotropy K = 1 x 10⁵ J/m³, an exchange constant A_{exch} = 2 x 10⁻¹¹ J/m, a shared free layer thickness of 3 nm, a device width of 30 nm, and a device length of 120 nm were assumed. The device was found starting to be operational at ≈ 10¹⁰ A/m² until = 10¹² A/m².

For the y-shape embodiment shown in Fig. 6 it takes between one and two orders of magnitude larger current densities depending on leg angle and length. Switching speed depends on the applied current density and ranges from tens of nanoseconds to picoseconds.

In a further embodiment, in order to reduce the required current densities, oxide non-magnetic layers 3 such as MgO are used. This raises the spin current polarization to about 0.6 - 1. In a further embodiment, a further tunnel barrier is provided below the shared free layer 2 to add a further STT contribution supporting the switching process.

In order to further illustrate practical applications of the invented non-volatile magnetic integrated circuit 1, several non-limiting embodiments of shift register topologies and their operation are shown.

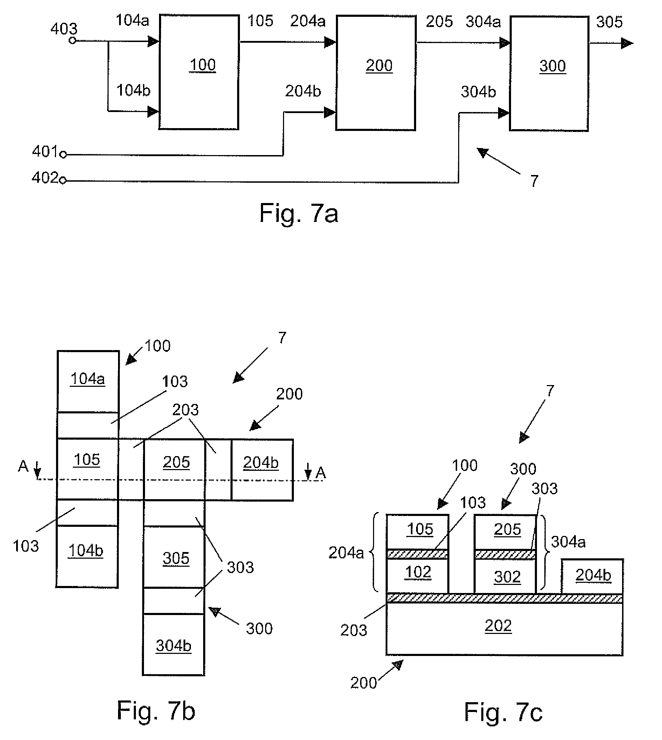

Figs. 7a-7c show a first working example of a non-volatile shift register 7 comprising three non-volatile magnetic integrated ciruits 100, 200, 300, where the contact layers 8 have been omitted for clarity. For the sake of simplicity only three circuits 100, 200, and 300 are shown, but the extension to larger non-volatile shift registers is straightforward.

Fig. 7a shows the circuit diagram of the shift register 7 with the integrated circuits 100, 200, and 300 connected in series and working as flip flops. The input signal 403 is attached to the input regions 104a, 104b of the first circuit 100. The output region 105 of the first circuit 100 is equivalent to the input region 204a of the second circuit 200, and the output region 205 of the second circuit 200 is equivalent to the input region 304a of the third circuit 300. The second input regions 204b, 304b of the circuits 200 and 300 are driven by independent clock signals 401 and 402.

Fig. 7b shows a schematic top view of the layout of the shift register 7, and Fig. 7c shows a schematic cross section along the cut A-A of Fig. 7b. The circuits 100, 200, and 300 are placed in two distinct levels. In further embodiments, they could also be arranged in multiple levels. A first flip flop circuit 100 has signal input regions 104a and 104b and a signal output region 105. The signal output region 105 is arranged in such a way that it operates as signal input region 204a of the second circuit 200. The second circuit 200 has a second signal input region 204b, and a signal output region 205. The signal output region 205 works as a signal input region 304a of the third circuit 300. This scheme can be repeated as long as necessary to achieve the desired number of stages of the shift register.

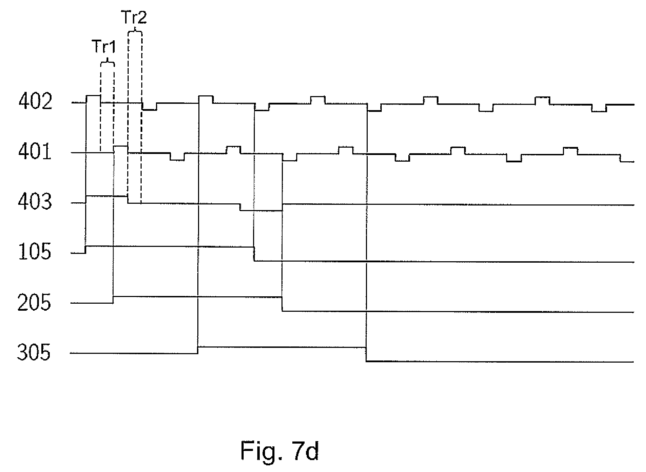

Fig. 7d shows a timing diagram of the shift register. Clock signals 401, 402 comprise a periodic signal with a first pulse, a relaxation window Tr1, Tr2 without any signal, and a second pulse with opposite polarity to the first pulse within its period. The relaxation windows Tr1, Tr2 are required for relaxation. The time slot in between electrically decouples the two distinct levels. Two pulses, positive and negative, are needed to copy the state from the preceding non-volatile magnetic flip flop 100 into the subsequent non-volatile magnetic flip flop 200.

Additionally, there may be further time slots without any signal to allow data readout (e.g. serial to parallel data conversion).

A current or voltage pulse input signal 403 is applied to the signal input regions 104a and 104b. During the write operation of the non-volatile magnetic flip flop 100 the non-volatile magnetic flip flop 200 is electrically inactive. After the corresponding writing pulses there is a sufficient relaxation window Tr1, such as several nanoseconds, where no signal is applied in order to relax the magnetization in the shared free layer to the desired state. The length of the relaxation window depends on the application, but is generally in the regime of picoseconds to tens of nanoseconds. Then the circuit 100 is in read mode and its shared free layer 102 is used as a reference layer for the input of the second circuit 200 while the second signal input region 204b receives a first clock signal 401.

The information stored in shared free layer 102 is passed to the shared free layer 202 via STT effect by a spin polarized current flowing from the reference layer in the signal output region 105 stack through the non-magnetic layer 203.

As an alternative embodiment, the non-magnetic layer 103 can comprise a metallic material. In this case, non-magnetic layer 103 can be contacted directly and the space between the signal input regions 104a, 104b and signal output region 105 can be used for feeding leads.

Since in read mode only the signal output region 105 is powered, only half the spin torque is exerted on shared free layer 102 and the spin disturbance path to a reflecting boundary and the power gain region is doubled. Thus, it takes much longer to flip the shared free layer 102 than to flip the shared free layer 202 which is in write mode with two active signal input regions 204a, 204b. This enables a non-disturbing readout.

The current or voltage pulses applied to the signal input region 204a must be synchronous to clock signal 401 at signal input region 204b but their polarity must be fixed. This is required due to the two intrinsic flip flop logic types (AB and RS) and the additional degree of freedom, which is introduced by employing the shared free layer 102 as reference layer in order to fix it to AB flip flop logic.

After a time slot Tr2 for relaxing the shared free layer 202, which is already taken care of by the clock signal 401, the non-volatile magnetic flip flop 200 is switched from write to read mode.

This means the signal input regions 204a and 204b are without power, while the signal output region 205 is used to transfer its magnetization state via STT operation to the signal input region 304a and shared free layer 302 through the non-magnetic layer 303 to the subsequent non-volatile magnetic flip flop 300.

Again the input signal for signal input region 304a is synchronous to a second clock signal 402 and only exhibits one type of polarity. The clock signal 402 is shifted with respect to clock signal 401 in order to guarantee that either the first (preceding) level of flip flops or the second (subsequent) level of flip flops is in write (read) mode.

Thus, with every clock cycle of clock signal 401 and clock signal 402 a signal input 403 written in non-volatile magnetic flip flop 100 is successively copied into non-volatile magnetic flip flop 200 and from there to the non-volatile magnetic flip flop 300 and so on. By changing the phase and/or polarities of the clock signal 401, clock signal 402, and the other input signals the signal flow in the shift register can be reversed.

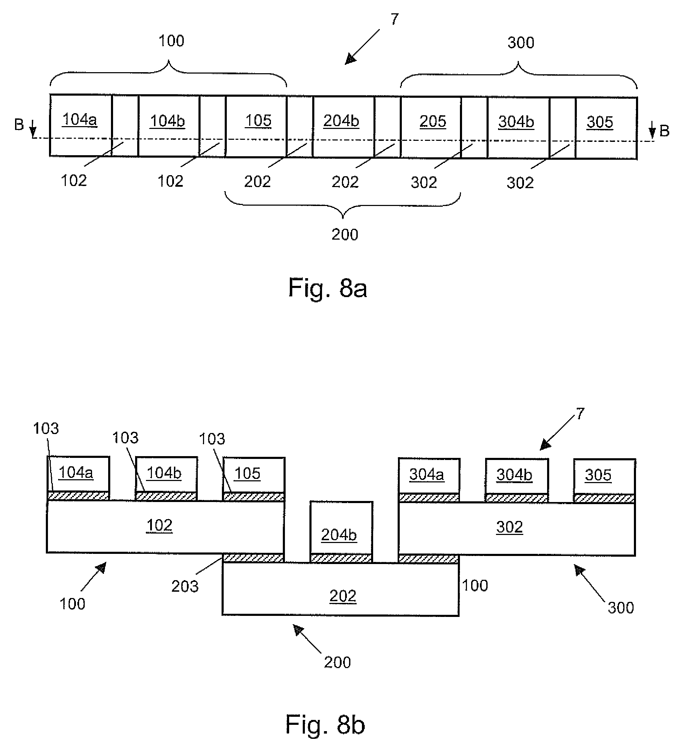

Figs. 8a - 8b show a second embodiment of a non-volatile shift register 7 according to the invention. Its operation principle is similar to the first embodiment, but it allows in-plane as well as out-of-plane anisotropies, because the layout of the circuits 100, 200, 300 does not have to be crossed. The non-volatile magnetic integrated circuits 1 are again arranged in two levels but instead of placing them crossed they are ordered along a line. Furthermore, signal input regions 104b, 204b, 304b changed place with signal output regions 105, 205, 305.

The signal input 403 is written into the circuit 100 synchronously to the clock signal 402. Since all non-volatile magnetic flip flops are operated in AB logic mode both input signals must exhibit the same polarity to set or reset the respective flip flop. Thus, applying a positive pulse sets the circuit 100 and the information is held, until it is reset. The information is copied to the second circuit 200, when clock signal 401 and the signal from signal output region 105, which is synchronous to signal 401 and has a fixed polarity, have the same polarity.

The information stored in circuit 200 is copied to non-volatile magnetic flip flop 300 over the output region 305, when clock signal 402 and the signal from signal output region 205, which is synchronous to signal 402 and has a fixed polarity, have the same polarity. Thus, information written into the non-volatile magnetic integrated circuit 100 by the input signal 403 is successively pushed through the whole shift register.

With the aid of these two working examples a person skilled in the art is able to amend the presented topologies in a way that fits his needs without any difficulties (e.g. 90° corners etc.).

By employing the above described devices and circuits one is able to realize truly instant on devices, save die space, ease large scale integration, operate at high speeds, and enable low power consumption. Since the described invention is CMOS compatible it may be used in hybrid circuits as well as spintronics only circuits working completely in magnetic domain via STT and spin disturbances.

The work leading to this invention has received funding from the European Research Council under the European Union's Seventh Framework Programme (FP7 / 2007-2013) / ERC grant agreement no. 247056 MOSILSPIN.

### List of reference numerals

- 1, 100, 200, 300: Spin torque magnetic integrated circuit
- 2, 102, 202, 302: Shared free layer
- 3, 203, 103, 303: Non-magnetic layer
- 4a, 104a, 204a, 304a,: First input region
- 4b, 104b, 2014b, 304b: Second input region
- 5, 105, 205, 305: Output region
- 6: Reference layer
- 7: Shift register
- 8: Capping layer
- 9: Second non-magnetic layer
- 401, 402: Clock signal
- 403: Signal input

## Claims

1. Non-volatile magnetic flip flop, comprising:
- a shared free layer (2) with a magnetic anisotropy such as a shape anisotropy or a crystal anisotropy with at least two stable magnetic states disposed on a substrate,
- a first non-magnetic layer (3) disposed on a first side of the free layer (2),
- input regions disposed on the non-magnetic layer (3),
- at least one output region (5) disposed on the non-magnetic layer (3), comprising at least one output layer (6),
- capping layers (8) to electrically contact the input regions (4a, 4b) and output region (5),
**characterized in that**
only two input regions (4a, 4b) are disposed on the non-magnetic layer (3), wherein one of the input regions (4a, 4b) comprises at least one magnetic input reference layer (6), and
the orientation of the magnetization vectors of the input reference layer, the output reference layer, and the orientation of the magnetic anisotropy of the free layer are collinear.

2. Non-volatile magnetic flip flop according to claim 1, **characterized in that** both input regions (4a, 4b) comprise at least one magnetic input reference layer (6).

3. Non-volatile magnetic flip flop according to claim 1 or 2, **characterized in that** at least one magnetization vector of the input reference layers of the input regions (4a, 4b) has the same direction or the opposite direction as the magnetization vector of the reference layer of the output region (5).

4. Non-volatile magnetic flip flop according to any of the preceding claims, **characterized in that** the easy axis of the magnetic anisotropy of the free layer, the input reference layer, and the output reference layer are oriented substantially in-plane with the substrate.

5. Non-volatile magnetic flip flop according to any of the preceding claims, **characterized in that** the easy axis of the magnetic anisotropy of the free layer, the input reference layer, and the output reference layer are oriented substantially out-of-plane in relation to the substrate.

6. Non-volatile magnetic flip flop according to any of the preceding claims, **characterized in that** a second non-magnetic layer (9) is disposed on a second side of the free layer (2), and at least one electrically contactable input and/or output region comprising at least one magnetic fixed reference layer is disposed on the second non-magnetic layer (9) to reduce the switching current.

7. Non-volatile magnetic flip flop according to any of the preceding claims, **characterized in that** the non-magnetic layer covers the shared free layer only partially, particularly only in the signal input regions and signal output regions.

8. Method to operate a non-volatile magnetic flip flop according to any of the preceding claims in sequential logic operation, such as in flip flop or shift register operation, **characterized in that** the method comprises the following steps:
- electrical current or voltage signals representing logic states are applied simultaneously at the two signal input regions (4a, 4b);
- the electrical current or voltage signals and any sensing currents or voltages are removed for a certain time period to relax the magnetic state of the spin torque magnetic integrated circuit;
- within a time period, the logic state of the shared free layer is read out by a sense amplifier utilizing a sensing current or sensing voltage.

9. Method according to claim 8, **characterized in that** the logic state of the shared free layer is read out by sensing the difference in electrical resistance for parallel and anti-parallel orientation of the input or output regions to the reference layer magnetization.

10. Method according to claim 8, **characterized in that** the logic state of the shared free layer is read out by passing the magnetization via STT operation to an adjacent shared free layer (2) of a second non-volatile magnetic integrated circuit (1).

11. Spin torque magnetic integrated circuit comprising
- a first flip flop according to any of the claims 1 to 7, and
- a second flip flop according to any of claims 1 to 7,
**characterized in that** at least one reference layer (6) of the first flip flop comprises a part of the free layer (2) of the second flip flop.

12. Spin torque magnetic integrated circuit according to claim 11, **characterized in that** the first flip flop and the second flip flop are arranged in different levels, preferably stacked.

13. Spin torque magnetic integrated circuit according to claim 11 or 12, **characterized in that** the reference layer (6) of a signal input region (4) of the second flip flop comprises the free layer (2) of the first flip flop.

14. Spin torque magnetic integrated circuit according to any of claims 11 to 13, **characterized in that** at least a third flip flop according to any of the claims 1 to 7 is provided, where at least one reference layer of the third flip flop comprises the shared layer of any of the first or second flip flop.

15. Method to operate a spin torque magnetic integrated circuit according to any of claims 11 to 14 in sequential logic operation, such as in flip flop or shift register operation, **characterized in that** the method comprises the following steps:
- a first clock signal (401) is applied to the input region of the first circuit;
- a second clock signal (402) is applied to the input region of the second circuit;
- where the first clock signal and the second clock signal are phase-shifted, and
- the first clock signal (401) and the second clock signal (403) are provided in such a way that there is a relaxation time window between the pulses of the clock signals during which the first circuit and the second circuit are unpowered.

## Patentansprüche

1. Nicht flüchtiger, magnetischer Flip-Flop, umfassend:
- eine gemeinsame freie Schicht (2) mit magnetischer Anisotropie, wie eine Formanisotropie oder eine Kristallanisotropie mit zumindest zwei stabilen Magnetzuständen, die auf einer Trägerschicht angeordnet ist,
- eine erste nicht magnetische Schicht (3), die auf einer ersten Seite der freien Schicht (2) angeordnet ist,
- Eingaberegionen, die auf der nicht magnetischen Schicht (3) angeordnet sind,
- zumindest eine Ausgaberegion (5), die auf der nicht magnetischen Schicht (3) angeordnet ist, umfassend zumindest eine Ausgabeschicht (6),
- Deckschichten (8) zum elektrischen Kontaktieren der Eingaberegionen (4a, 4b) und Ausgaberegion (5),
**dadurch gekennzeichnet, dass**
nur zwei Eingaberegionen (4a, 4b) auf der nicht magnetischen Schicht (3) angeordnet sind,
wobei eine der Eingaberegionen (4a, 4b) zumindest eine magnetische Eingabereferenzschicht (6) aufweist und
die Orientierung der Magnetisierungsvektoren der Eingabereferenzschicht, der Ausgabereferenzschicht und die Orientierung der magnetischen Anisotropie der freien Schicht kolinear sind.

2. Nicht flüchtiger, magnetischer Flip-Flop nach Anspruch 1, **dadurch gekennzeichnet, dass** beide Eingaberegionen (4a, 4b) zumindest eine magnetische Eingabereferenzschicht (6) aufweisen.

3. Nicht flüchtiger, magnetischer Flip-Flop nach Anspruch 1 oder 2, **dadurch gekennzeichnet, dass** zumindest ein Magnetisierungsvektor der Eingabereferenzschichten der Eingaberegionen (4a, 4b) dieselbe Richtung oder die entgegengesetzte Richtung wie der Magnetisierungsvektor der Referenzschicht der Ausgaberegion (5) hat.

4. Nicht flüchtiger, magnetischer Flip-Flop nach einem der vorangehenden Ansprüche, **dadurch gekennzeichnet, dass** die leichte Richtung der magnetischen Anisotropie der freien Schicht, der Eingabereferenzschicht und der Ausgabereferenzschicht im Wesentlichen in einer Ebene mit der Trägerschicht orientiert sind.

5. Nicht flüchtiger, magnetischer Flip-Flop nach einem der vorangehenden Ansprüche, **dadurch gekennzeichnet, dass** die leichte Richtung der magnetischen Anisotropie der freien Schicht, der Eingabereferenzschicht und der Ausgabereferenzschicht im Wesentlichen außerhalb der Ebene in Relation zur Trägerschicht orientiert sind.

6. Nicht flüchtiger, magnetischer Flip-Flop nach einem der vorangehenden Ansprüche, **dadurch gekennzeichnet, dass** eine zweite nicht magnetische Schicht (9) auf einer zweiten Seite der freien Schicht (2) angeordnet ist und zumindest eine elektrisch kontaktierbare Eingabe- und/oder Ausgaberegion, die zumindest eine magnetisch feste Referenzschicht umfasst, auf der zweiten nicht magnetischen Schicht (9) zur Verringerung des Schaltstroms angeordnet sind.

7. Nicht flüchtiger, magnetischer Flip-Flop nach einem der vorangehenden Ansprüche, **dadurch gekennzeichnet, dass** die nicht magnetische Schicht die gemeinsame freie Schicht nur teilweise bedeckt, insbesondere in den Signaleingaberegionen und Signalausgaberegionen.

8. Verfahren zum Betreiben eines nicht flüchtigen, magnetischen Flip-Flops nach einem der vorangehenden Ansprüche in einer sequenziellen logischen Operation, wie in einer Flip-Flop- oder Schieberegisteroperation, **dadurch gekennzeichnet, dass** das Verfahren die folgenden Schritte umfasst:
- elektrische Strom- oder Spannungssignale, die logische Zustände darstellen, werden gleichzeitig an die zwei Signaleingaberegionen (4a, 4b) angelegt;
- die elektrischen Strom- oder Spannungssignale und sämtliche Erfassungsströme oder -spannungen werden für eine gewisse Zeitperiode entfernt, um den Magnetzustand des integrierten, magnetischen Spin-Drehmoment-Schaltkreises zu entspannen;
- innerhalb einer Zeitperiode wird der logische Zustand der gemeinsamen freien Schicht von einem Leseverstärker unter Verwendung eines Erfassungsstroms oder einer Erfassungsspannung ausgelesen.

9. Verfahren nach Anspruch 8, **dadurch gekennzeichnet, dass** der logische Zustand der gemeinsamen freien Schicht durch Erfassen der Differenz im elektrischen Widerstand für eine parallele und nicht parallele Orientierung der Eingabe- oder Ausgaberegionen zur Referenzschichtmagnetisierung ausgelesen wird.

10. Verfahren nach Anspruch 8, **dadurch gekennzeichnet, dass** der logische Zustand der gemeinsamen freien Schicht durch Weiterleiten der Magnetisierung über eine STT-Operation zu einer benachbarten freien Schicht (2) einer zweiten, nicht flüchtigen, magnetischen, integrierten Schaltung (1) ausgelesen wird.

11. Integrierter magnetischer Spin-Drehmoment-Schaltkreis, umfassend:
- einen ersten Flip-Flop nach einem der Ansprüche 1 bis 7 und
- einen zweiten Flip-Flop nach einem der Ansprüche 1 bis 7,
**dadurch gekennzeichnet, dass** zumindest eine Referenzschicht (6) des ersten Flip-Flops einen Teil der freien Schicht (2) des zweiten Flip-Flops umfasst.

12. Integrierter magnetischer Spin-Drehmoment-Schaltkreis nach Anspruch 11, **dadurch gekennzeichnet, dass** der erste Flip-Flop und der zweite Flop-Flop in verschiedenen Ebenen angeordnet, vorzugsweise gestapelt sind.

13. Integrierter magnetischer Spin-Drehmoment-Schaltkreis nach Anspruch 11 oder 12, **dadurch gekennzeichnet, dass** die Referenzschicht (6) einer Signaleingaberegion (4) des zweiten Flip-Flops die freie Schicht (2) des ersten Flip-Flops umfasst.

14. Integrierter magnetischer Spin-Drehmoment-Schaltkreis nach einem der Ansprüche 11 bis 13, **dadurch gekennzeichnet, dass** zumindest ein dritter Flip-Flop nach einem der Ansprüche 1 bis 7 vorgesehen ist, wobei zumindest eine Referenzschicht des dritten Flip-Flops die gemeinsame Schicht von dem ersten oder zweiten Flip-Flop umfasst.

15. Verfahren zum Betreiben eines integrierten magnetischen Spin-Drehmoment-Schaltkreises nach einem der Ansprüche 11 bis 14 in einer sequenziellen logischen Operation, wie in einer Flip-Flop- oder Schieberegisteroperation, **dadurch gekennzeichnet, dass** das Verfahren die folgenden Schritte umfasst:
- ein erstes Taktsignal (401) wird an die Eingaberegion der ersten Schaltung angelegt;
- ein zweites Taktsignal (402) wird an die Eingaberegion der zweiten Schaltung angelegt;
- wobei das erste Taktsignal und das zweite Taktsignal phasenverschoben sind und
- das erste Taktsignal (401) und das zweite Taktsignal (403) derart ausgeführt sind, dass es ein Entspannungszeitfenster zwischen den Pulsen der Taktsignale gibt, in welchem die erste Schaltung und die zweite Schaltung nicht mit Strom versorgt sind.

## Revendications

1. Circuit bistable magnétique non-volatile, comprenant :
- une couche libre partagée (2) ayant une anisotropie magnétique, comme une anisotropie de forme ou une anisotropie cristalline, avec au moins deux états magnétiques stables, disposée sur un substrat,
- une première couche non-magnétique (3) disposée sur un premier côté de la couche libre (2),
- des régions d'entrée disposées sur la couche non-magnétique (3),
- au moins une zone de sortie (5) disposée sur la couche non-magnétique (3), comprenant au moins une couche de sortie (6),
- des moyens de recouvrement (8) pour contacter électriquement les régions d'entrée (4a, 4b) et la région de sortie (5),
**caractérisé en ce que**
seules deux régions d'entrée (4a, 4b) sont disposées sur la couche non-magnétique (3),
sachant que l'une des régions d'entrée (4a, 4b) comprend au moins une couche d'entrée magnétique de référence (6), et
l'orientation des vecteurs de magnétisation de la couche de référence d'entrée, de la couche de référence de sortie, et l'orientation de l'anisotropie magnétique de la couche libre sont colinéaires.

2. Circuit bistable magnétique non-volatile selon la revendication 1, **caractérisé en ce que** les deux régions d'entrée (4a, 4b) comprennent au moins une couche d'entrée magnétique de référence (6).

3. Circuit bistable magnétique non-volatile selon la revendication 1 ou 2, **caractérisé en ce qu'**au moins un vecteur de magnétisation des couches d'entrée de référence des régions d'entrée (4a, 4b) a la même direction, ou la direction opposée, que le vecteur de magnétisation de la couche de référence de la région de sortie (5).

4. Circuit bistable magnétique non-volatile selon l'une quelconque des revendications précédentes, **caractérisé en ce que** l'axe facile de l'anisotropie magnétique de la couche libre, de la couche d'entrée de référence et de la couche de sortie est orienté essentiellement dans le plan avec le substrat.

5. Circuit bistable magnétique non-volatile selon l'une quelconque des revendications précédentes, **caractérisé en ce que** l'axe facile de l'anisotropie magnétique de la couche libre, de la couche d'entrée de référence et de la couche de sortie de référence est orienté essentiellement hors du plan par rapport au substrat.

6. Circuit bistable magnétique non-volatile selon l'une quelconque des revendications précédentes, **caractérisé en ce qu'**une seconde couche non-magnétique (9) est disposée sur un second côté de la couche libre (2), et au moins une région d'entrée et/ou de sortie pouvant être contactée(s) électriquement, comprenant au moins une couche fixe magnétique de référence, est/sont disposée(e) sur la seconde couche non-magnétique (9) pour réduire le courant de commutation.

7. Circuit bistable magnétique non-volatile selon l'une quelconque des revendications précédentes, **caractérisé en ce que** la couche non-magnétique couvre la couche libre partagée uniquement partiellement, particulièrement uniquement dans les régions d'entée de signal et les régions de sortie de signal.

8. Procédé de fonctionnement d'un circuit bistable magnétique non-volatile selon l'une quelconque des revendications précédentes dans une opération logique séquentielle, telle qu'une opération de registre bistable ou à décalage, **caractérisé en ce que** le procédé comprend les étapes suivantes :
- des signaux de courant ou de tension électriques représentant des états logiques sont appliqués simultanément sur les deux régions d'entrée de signal (4a, 4b) ;
- les signaux de courant ou de tension électriques et tout courant ou tension de détection sont retirés pendant un certain délai pour relâcher l'état magnétique du circuit intégré magnétique à couple de spin ;
- pendant un délai, l'état logique de la couche libre partagée est lu par un amplificateur de détection utilisant un courant ou une tension de détection.

9. Procédé selon la revendication 8, **caractérisé en ce que** l'état logique de la couche libre partagée est lu en détectant la différence de résistance électrique pour l'orientation parallèle et anti-parallèle des régions d'entrée ou de sortie par rapport à la magnétisation de la couche de référence.

10. Procédé selon la revendication 8, **caractérisé en ce que** l'état logique de la couche libre partagée est lu en passant la magnétisation par une opération STT vers une couche libre partagée adjacente (2) d'un deuxième circuit intégré magnétique non-volatile (1).

11. Circuit intégré magnétique à couple de spin comprenant
- un premier circuit bistable selon l'une quelconque des revendications 1 à 7, et
- un deuxième circuit bistable selon l'une quelconque des revendications 1 à 7,
**caractérisé en ce qu'**au moins une couche de référence (6) du premier circuit bistable comprend une partie de la couche libre (2) du deuxième circuit bistable.

12. Circuit intégré magnétique selon la revendication 11, **caractérisé en ce que** le premier circuit bistable et le deuxième circuit bistable sont agencés à différents niveaux, de préférence empilés.

13. Circuit intégré magnétique selon la revendication 11 ou 12, **caractérisé en ce que** la couche de référence (6) d'une région d'entrée de signal (4) du deuxième circuit bistable comprend la couche libre (2) du premier circuit bistable.

14. Circuit intégré magnétique selon l'une quelconque des revendications 11 à 13, **caractérisé en ce qu'**au moins un troisième circuit bistable selon l'une quelconque des revendications 1 à 7 est prévu, sachant qu'au moins une couche de référence du troisième circuit bistable comprend la couche partagée de l'un quelconque des premier ou deuxième circuit(s) bistable(s).

15. Procédé de fonctionnement d'un circuit intégré magnétique à couple de spin selon l'une quelconque des revendications 11 à 14 dans une opération logique séquentielle, telle qu'une opération de registre bistable ou à décalage, **caractérisé en ce que** le procédé comprend les étapes suivantes :
- un premier signal d'horloge (401) est appliqué à la région d'entrée du premier circuit ;
- un second signal d'horloge (402) est appliqué à la région d'entrée du deuxième circuit ;
- sachant que le premier signal d'horloge et le second signal d'horloge sont déphasés, et
- le premier signal d'horloge (401) et le second signal d'horloge (403) sont prévus de telle façon qu'il y a une fenêtre de temps de relâchement entre les impulsions des signaux d'horloge pendant laquelle le premier circuit et le deuxième circuit ne sont pas alimentés.
